# EUROPEAN PATENT APPLICATION

(11) **EP 4 383 283 A1**
(43) Date of publication of application: **12.06.2024**
(21) Application number: 22852901.2
(22) Date of filing: 26.07.2022
(51) Int. Cl.: H01C 13/00, H01C 7/00

(54) **CHIP RESISTOR AND METHOD FOR MANUFACTURING CHIP RESISTOR**

(30) Priority: 06.08.2021 JP 2021130065
(71) Applicant: Panasonic Intellectual Property Management Co., Ltd., Kadoma-shi, Osaka 571-0057 (JP)
(72) Inventor: SUETSUGU, Daisuke, Kadoma-shi, Osaka 571-0057 (JP); NOGUCHI, Norimichi, Kadoma-shi, Osaka 571-0057 (JP); TAKAGI, Nobutoshi, Kadoma-shi, Osaka 571-0057 (JP); ODA, Hiroki, Kadoma-shi, Osaka 571-0057 (JP); URAKAWA, Tatsuya, Kadoma-shi, Osaka 571-0057 (JP)
(74) Representative: Novagraaf International SA
(86) International application number: PCT/JP2022/028781
(87) International publication number: WO 2023/013478

(57) **Abstract**

A chip resistor capable of achieving both high specific resistance, a low TCR is provided. A chip resistor includes: an insulating substrate; a resistive layer formed of an alloy containing Cr, Si, and N, the resistive layer being provided on the insulating substrate; and a first high-nitrogen-containing layer provided on the resistive layer, the first high-nitrogen-containing layer being made of an alloy having a N atomic percentage higher than a N atomic percentage of the resistive layer.

## Description

### BACKGROUND

### 1. Technical Field

The present invention relates generally to a chip resistor and a method for manufacturing the chip resistor, and more particularly to a chip resistor used in an electronic device and a method for manufacturing the chip resistor.

### 2. Description of the Related Art

A conventional chip resistor of this type includes an insulating substrate and a thin film resistor provided on an upper surface of the substrate, and in particular, there is a chip resistor made of Cr, Si, O, and N as a composition of the resistor excellent in specific resistance and a temperature coefficient of resistance (TCR) (see, for example, JP 2020-170843 A).

As prior art document information on the invention of this application is known as JP 2020-170843 A.

### SUMMARY

In the above-described conventional chip resistor, the thin-film resistor has excellent electrical characteristics such as a high specific resistance of 500 to 20,000 µΩ·cm and a temperature coefficient of resistance (TCR) of ±25 ppm/K or less. For example, when the film thickness of the resistor is reduced to less than 100 nm in order to obtain a higher resistance value, there is a problem that variations in the characteristics of the finished chip resistor increase due to variations in manufacturing conditions such as heat treatment, and the yield decreases.

The present disclosure was conceived in view of the situations, and it is therefore one non-limiting and exemplary embodiment provides a chip resistor capable of achieving both high specific resistance, a low TCR, and stable production with little variation, and a method for manufacturing the chip resistor.

In one general aspect, the techniques disclosed here feature: a chip resistor includes:
an insulating substrate;
a resistive layer formed of an alloy containing Cr, Si, and N, the resistive layer being provided on the insulating substrate; and
a first high-nitrogen-containing layer provided on the resistive layer, the first high-nitrogen-containing layer being made of an alloy having a N atomic percentage higher than a N atomic percentage of the resistive layer.

In another general aspect, the techniques disclosed here feature: a method for manufacturing a chip resistor comprising:
providing an insulating substrate;
forming a resistive layer made of an alloy containing Cr, Si, and N on the insulating substrate by reactive sputtering in an atmosphere of a film-forming gas containing nitrogen;
forming a first high-nitrogen-containing layer made of an alloy containing Cr, Si, and N and having a N atomic percentage higher than a N atomic percentage of the resistive layer on the resistive layer by reactive sputtering in an atmosphere of a nitrogen-containing film-forming gas; and
performing a heat treatment in a temperature range between 500°C and 700°C both inclusive in an atmosphere containing oxygen to adjust a temperature coefficient of resistance (TCR) indicating a change in resistance per degree of absolute temperature of the resistive layer, and oxidizing a part of a surface of the first high-nitrogen-containing layer to form an oxide layer.

According to the chip resistor and the method for manufacturing the chip resistor according to the present invention, since the first high-nitrogen-containing layer is provided on the resistive layer, the characteristic change with respect to the treatment temperature in the heat treatment step is gentle even when the film thickness of the resistive layer is as thin as less than 100 nm, and it is possible to achieve both high specific resistance, a low TCR, and stable production with little variation.

### BRIEF DESCRIPTION OF THE DRAWINGS

Fig. 1 is a cross-sectional view illustrating a cross-sectional structure of a chip resistor according to a first embodiment.
Fig. 2 is a cross-sectional view illustrating a detailed cross-sectional structure of a resistive layer and a first high-nitrogen-containing layer formed on the resistive layer in the chip resistor according to the first embodiment.
Fig. 3 is a cross-sectional view illustrating details of a resistive layer and first and second high-nitrogen-containing layers formed on upper and lower of the resistive layer in a first modification of the chip resistor according to the first embodiment.
Fig. 4 is a graph showing a relationship between a heat treatment temperature and a TCR in the chip resistor according to the first embodiment.
Fig. 5 is a graph showing a relationship between a heat treatment temperature and a resistance value in the chip resistor according to the first embodiment.
Fig. 6 is a cross-sectional view illustrating details of a resistor regarding a conventional chip resistor.

### DETAILED DESCRIPTION

A chip resistor according to a first aspect, includes:
an insulating substrate;
a resistive layer formed of an alloy containing Cr, Si, and N, the resistive layer being provided on the insulating substrate; and
a first high-nitrogen-containing layer provided on the resistive layer, the first high-nitrogen-containing layer being made of an alloy having a N atomic percentage higher than a N atomic percentage of the resistive layer.

According to the above configuration, since the first high-nitrogen-containing layer is provided on the resistive layer, even when the thickness of the resistive layer is as thin as less than 100 nm, the resistive layer has high specific resistance and a low TCR.

Further, as a chip resistor of a second aspect, in the first aspect, the chip resistor may include a second high-nitrogen-containing layer made of an alloy having a N atomic percentage higher than a N atomic percentage of the resistive layer, the second high-nitrogen-containing layer being between the insulating substrate and the resistive layer.

According to the above configuration, the resistance of the resistive layer can be further increased.

Further, as a chip resistor of a third aspect, in the first aspect, a film thickness of the first high-nitrogen-containing layer may be 1,000 nm or less.

According to the above configuration, manufacture is possible at low cost while achieving both high resistance and a low TCR.

Further, as a chip resistor of a fourth aspect, in the first aspect, the composition of the alloy of the first high-nitrogen-containing layer may be 40 atom% or more in a N atomic percentage.

According to the above configuration, the resistance value of the resistive layer can be further increased.

Further, as a chip resistor of a fifth aspect, in the first aspect, the alloy of the first high-nitrogen-containing layer may contain at least one element selected from a group including Cr, Nb, Ta, Al, and Si.

According to the above configuration, the resistance value of the resistive layer can be further increased.

Further, as a chip resistor of a sixth aspect, in the first aspect, a composition ratio excluding elements O and N of the alloy of the first high-nitrogen-containing layer may be matched with a composition ratio excluding elements O and N of the alloy of the resistive layer in a range of ±5 atom% for each constituent element.

According to the above configuration, manufacture is possible at low cost while achieving both high resistance and a low TCR.

A method for manufacturing a chip resistor according to a seventh aspect, includes:
providing an insulating substrate;
forming a resistive layer made of an alloy containing Cr, Si, and N on the insulating substrate by reactive sputtering in an atmosphere of a film-forming gas containing nitrogen;
forming a first high-nitrogen-containing layer made of an alloy containing Cr, Si, and N and having a N atomic percentage higher than a N atomic percentage of the resistive layer on the resistive layer by reactive sputtering in an atmosphere of a nitrogen-containing film-forming gas; and
performing a heat treatment in a temperature range between 500°C and 700°C both inclusive in an atmosphere containing oxygen to adjust a temperature coefficient of resistance (TCR) indicating a change in resistance per degree of absolute temperature of the resistive layer, and oxidizing a part of a surface of the first high-nitrogen-containing layer to form an oxide layer.

According to the above configuration, since the first high-nitrogen-containing layer is provided on the resistive layer, even when the film thickness of the resistive layer is as thin as less than 100 nm, the characteristic change with respect to the treatment temperature in the heat treatment step is gentle, and it is possible to achieve both high specific resistance, a low TCR, and stable production with little variation.

Further, as a method for manufacturing a chip resistor of an eighth aspect, in the seventh aspect, in the forming the resistive layer and the forming the first high-nitrogen-containing layer, the N atomic percentage in the resistive layer and the N atomic percentage in the first high-nitrogen-containing layer are respectively controlled by the ratio of nitrogen gas contained in the film-forming gas.

According to the above configuration, the N atomic percentage of the first high-nitrogen-containing layer can be made higher than that of the resistive layer.

Further, as a method for manufacturing a chip resistor of a ninth aspect, in the seventh aspect, in the forming the resistive layer and the forming the first high-nitrogen-containing layer, the N atomic percentage in the resistive layer and the N atomic percentage in the first high-nitrogen-containing layer are respectively controlled by an on-duty ratio of an applied pulse in the reactive sputtering.

According to the above configuration, the N atomic percentage of the first high-nitrogen-containing layer can be made higher than that of the resistive layer.

Hereinafter, a chip resistor according to an embodiment and a method for manufacturing the chip resistor will be described with reference to the accompanying drawings. In the drawings, substantially the same members are denoted by the same reference numerals.

### (First Embodiment)

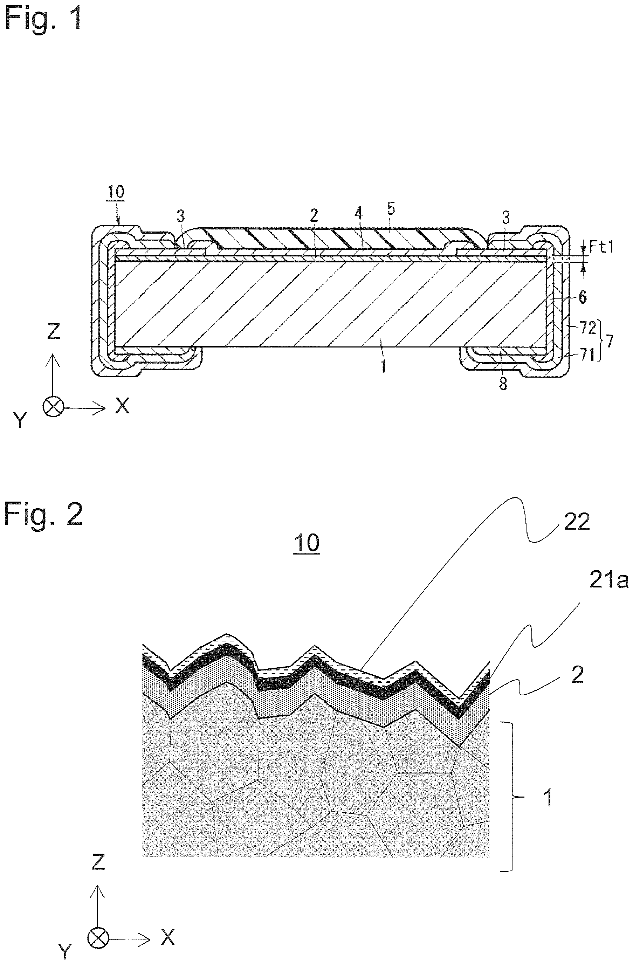

Hereinafter, a chip resistor 10 and a method for manufacturing the chip resistor 10 according to the first embodiment will be described with reference to Figs. 1 to 6. For convenience, a direction in which a current flows in a resistive layer 2 is defined as an X direction, a direction perpendicular to the layer is defined as a Z direction, and a direction from a front side to a back side of the sheet is defined as a Y direction.

However, the embodiments and modifications described below are merely examples of the present disclosure, and the present disclosure is not limited to the following embodiments and modifications. Other than the following embodiments and modifications, various modifications can be made according to design and the like without departing from the technical idea of the present disclosure.

Each of the drawings described in the following embodiments and the like is a schematic view, and the ratio of the size and the thickness of each component in each drawing does not necessarily reflect the actual dimensional ratio.

### (1) Outline of chip resistor

First, an outline of the chip resistor 10 according to the first embodiment will be described with reference to Fig. 1.

The chip resistor 10 according to the first embodiment is a surface mount (SMT) chip resistor mounted on a surface (mounting surface) of a printed circuit board using, for example, a surface mount machine (mounter). The chip resistor 10 according to the first embodiment is, for example, a thin film chip resistor.

As illustrated in Fig. 1, the chip resistor 10 according to the first embodiment includes an insulating substrate 1 and a resistive layer 2. In the first embodiment, the resistive layer 2 contains Cr (chromium), Si (silicon), and N (nitrogen). The resistive layer 2 is provided on the insulating substrate 1. A first high-nitrogen-containing layer 21a is provided on the surface of the resistive layer 2. The current flows in the +X direction or the -X direction.

In the chip resistor 10 according to the first embodiment, the N atomic percentage of the first high-nitrogen-containing layer 21a is higher than that of the resistive layer. As a result, even when the film thickness of the resistive layer 2 is small, oxidation of the surface of the resistive layer 2 is suppressed, and thus manufacture is possible with the low temperature coefficient of resistance (hereinafter, also referred to as "TCR"), the high specific resistance of the resistive layer 2, and these characteristics being stable.

### (2) Configuration of chip resistor

Next, a configuration of chip resistor 10 according to the present embodiment will be described with reference to Fig. 1.

As illustrated in Fig. 1, the chip resistor 10 according to the present embodiment includes the insulating substrate 1 and the resistive layer 2. In addition, the chip resistor 10 further includes a pair of upper-surface electrodes 3, a first protective film 4, a second protective film 5, a pair of end-surface electrodes 6, a pair of plating layers 7, and a pair of back-surface electrodes 8.

### (2.1) Insulating substrate

The insulating substrate 1 is, for example, an alumina substrate containing 96 wt% to 99 wt% of Al₂O₃ (alumina). The shape of the insulating substrate 1 in plan view is, for example, a rectangular shape.

### (2.2) Resistive layer, first high-nitrogen-containing layer, and surface oxynitride layer

The resistive layer 2, the first high-nitrogen-containing layer 21, and the surface nitrided layer will be described with reference to Fig. 2.

The resistive layer 2 is a thin film and is provided on one surface (upper surface in Fig. 2) of the insulating substrate 1. The resistive layer 2 is made of, for example, an alloy of Cr (chromium), Si (silicon), and N (nitrogen). The atomic ratio of Cr and Si in the resistive layer 2 is 3 : 2 or more and 1 : 4 or less. The total amount of atoms of N in the total amount of atoms of the metal constituting the resistive layer 2 is, for example, 1 atom% or more and 40 atom% or less. In other words, the N atomic percentage in the resistive layer 2 is at least 1 atom% or more and 40 atom% or less at the center of the resistive layer 2 in the film thickness direction of the resistive layer 2.

The resistive layer 2 may further contain O (oxygen). The O atomic percentage in the resistive layer 2 is, for example, 10 atom% or less at least at the center of the resistive layer 2 in the film thickness direction of the resistive layer 2.

The resistive layer 2 may contain at least one element selected from the group including Cr, Nb, Ta, Al, and Si in the alloy composition.

The first high-nitrogen-containing layer 21a is provided on the surface of the resistive layer 2.

In the chip resistor 10 according to the present embodiment, the first high-nitrogen-containing layer 21a is made of, for example, an alloy of Cr (chromium), Si (silicon), and N (nitrogen). The film thickness of the first high-nitrogen-containing layer is, for example, 1,000 nm or less. The first high-nitrogen-containing layer 21a has a higher N atomic percentage than that of the resistive layer 2 in the alloy composition. Specifically, the composition of the alloy of the first high-nitrogen-containing layer 21a may be 40 atom% or more in terms of N atomic percentage.

The first high-nitrogen-containing layer 21a may contain at least one element selected from the group including Cr, Nb, Ta, Al, and Si in the alloy composition. Since these oxides form a passive film, oxidation stops without proceeding. Therefore, a thin oxynitride film can be obtained.

The composition ratio of the alloy in the first high-nitrogen-containing layer 21a excluding O and N may be the same within a range of ±5 atom% for each constituent element with respect to the composition ratio of the alloy in the resistive layer 2 excluding O and N. That is, the first high-nitrogen-containing layer 21a and the resistive layer 2 have different nitrogen contents, but the types and contents of other elements may be substantially the same.

The atomic composition ratio of each layer of the resistive layer 2 and the first high-nitrogen-containing layer can be evaluated by using, for example, energy dispersive X-ray spectroscopy TEM-EDX or electron energy loss spectroscopy TEX-EELS accompanying a transmission electron microscope TEM. Specifically, the atomic composition ratio can be calculated from the spectral ratio obtained for each element of Cr, Si, N, and O with respect to the upper surface or the cross section of the resistive layer 2. Alternatively, the calculation can be made by correcting each atomic composition ratio evaluated using the X-ray photoelectron spectroscopy (XPS) on the basis of the correction coefficient of each element evaluated using the Rutherford backscattering spectrometry (RBS).

The surface oxynitride layer 22 is formed by oxidation by performing heat treatment on the first high-nitrogen-containing layer 21a in a heat treatment step described later. That is, the portion where the first high-nitrogen-containing layer 21a is oxidized is changed to the surface oxynitride layer 22, and the oxidation of the resistive layer 2 is suppressed instead. The surface oxynitride layer 22 has a thickness of, for example, 10 nm to 20 nm. The surface oxynitride layer 22 is made of, for example, an oxynitride film containing at least one element of Cr and Al and/or Si. In addition, a passive film is formed by Cr oxide contained in the surface oxynitride layer 22, thereby improving oxidation resistance.

The resistance value of the chip resistor 10 is represented by the sum of the resistance values of the resistive layer 2 and the first high-nitrogen-containing layer 21 connected substantially in parallel. Since the first high-nitrogen-containing layer 21 has a higher N atomic percentage than the resistive layer 2, the specific resistance is higher than that of the resistive layer 2. The surface oxynitride layer 22 is an insulator. Therefore, it is possible to suppress the fluctuation of the resistance value when the surface is oxidized by the heat treatment in the heat treatment step.

### (2.5) Upper-surface electrode

Each of the pair of upper-surface electrodes 3 is made of, for example, Cu. The pair of upper-surface electrodes 3 is provided so as to cover a part of the upper surface of the resistive layer 2 at both ends in the longitudinal direction (left-right direction in Fig. 1) of the resistive layer 2. The pair of upper-surface electrodes 3 is formed by, for example, forming a metal film on the entire upper surface of the resistive layer 2 by sputtering, and then removing the film at the central portion by photolithography and etching.

### (2.6) First protective film

The first protective film (inorganic protective film) 4 is a film for protecting the resistive layer 2. The first protective film 4 is made of, for example, Al₂O₃ (alumina). The first protective film 4 is located on the upper surface of the resistive layer 2. The first protective film 4 covers a part of the pair of upper-surface electrodes 3 at both ends in the longitudinal direction (left-right direction in Fig. 1). That is, the first protective film 4 covers the boundary between the resistive layer 2 and the pair of upper-surface electrodes 3 and continuously covers at least a part of the pair of upper-surface electrodes 3 from the resistive layer 2 as viewed from the film thickness direction D1 of the resistive layer 2 (the thickness direction of the insulating substrate 1). The first protective film 4 is formed by, for example, forming a protective film on the entire resistive layer 2 by sputtering, and then removing portions of both end portions by photolithography and etching.

In this way, the corrosion of the resistive layer 2 can be prevented by providing the first protective film 4. The first protective film 4 may be a metal oxide other than alumina, or a metal nitride. The first protective film 4 may be omitted.

### (2.7) Second protective film

The second protective film (resin protective film) 5 is made of, for example, an epoxy resin. The second protective film 5 covers the entire surface of the first protective film 4 and a part of the pair of upper-surface electrodes 3. That is, the second protective film 5 covers the boundary between the first protective film 4 and the pair of upper-surface electrodes 3 and continuously covers from the first protective film 4 to at least a part of the pair of upper-surface electrodes 3 as viewed from the film thickness direction D1 of the resistive layer 2 (thickness direction of the insulating substrate 1).

The second protective film 5 is formed, for example, by applying an epoxy resin by screen printing and then curing the epoxy resin by irradiation with ultraviolet rays. In the pair of upper-surface electrodes 3, a portion located between both end portions (portions covering the pair of upper-surface electrodes 3) in the longitudinal direction (left-right direction in Fig. 1) of the first protective film 4 and the plating layer 7 is directly covered with the second protective film 5.

### (2.8) End-surface electrode

Each of the pair of end-surface electrodes 6 is made of, for example, CuNi. The pair of end-surface electrodes 6 is located at both ends in the longitudinal direction (left-right direction in Fig. 1) of the insulating substrate 1. The pair of end-surface electrodes 6 is formed at both ends in the longitudinal direction of the insulating substrate 1 by sputtering, for example. The pair of end-surface electrodes 6 is electrically connected to the pair of upper-surface electrodes 3.

### (2.9) Plating layer

As shown in Fig. 1, each of the pair of plating layers 7 includes a Ni plating layer 71 and a Sn plating layer 72. Each of the pair of plating layers 7 is connected to a part of the corresponding upper-surface electrode 3 in the pair of upper-surface electrodes 3 and is in contact with the second protective film 5. Each of the pair of plating layers 7 covers the corresponding end-surface electrode 6 of the pair of end-surface electrodes 6.

### (2.10) Back-surface electrode

Each of the pair of back-surface electrodes 8 is made of, for example, an epoxy resin containing Ag (silver) as a conductive material. The pair of back-surface electrodes 8 is located at both ends in the longitudinal direction (left-right direction in Fig. 1) of the back surface (lower surface in Fig. 1) of the insulating substrate 1. The pair of back-surface electrodes 8 is formed, for example, by applying an epoxy resin to both ends in the longitudinal direction of the back surface of the insulating substrate 1 by screen printing, and then irradiating the epoxy resin with ultraviolet rays to cure the epoxy resin. The pair of back-surface electrodes 8 has a one-to-one correspondence with the pair of upper-surface electrodes 3. The pair of back-surface electrodes 8 may be omitted.

### (3) Method for manufacturing chip resistor

Next, a method for manufacturing the chip resistor 10 according to the first embodiment will be described.

The method for manufacturing the chip resistor 10 according to the first embodiment includes a step of providing an insulating substrate, a resistive layer forming step, a first high-nitrogen-containing layer forming step, and a heat treatment step.

In the step of providing an insulating substrate, the insulating substrate 1 is provided. For example, an alumina substrate is provided.

The resistive layer forming step is a step of forming the resistive layer 2 on the insulating substrate 1. In the first embodiment, in the resistive layer forming step, for example, the resistive layer 2 is formed on the insulating substrate 1 by reactive sputtering in which nitrogen is reacted or reactive sputtering in which nitrogen and oxygen are reacted in an atmosphere of a film-forming gas containing nitrogen. The sputtering target for the reactive sputtering contains, for example, Cr and Si, and the atomic ratio of Cr and Si is 3 : 7.

The first high-nitrogen-containing layer forming step is a step of forming the first high-nitrogen-containing layer 21a on the resistive layer 2. In the present embodiment, in the first high-nitrogen-containing layer forming step, for example, the first high-nitrogen-containing layer 21a is formed on the insulating substrate 1 by reactive sputtering reacted with nitrogen in an atmosphere of the film-forming gas containing nitrogen. In the sputtering target of reactive sputtering, for example, the atomic ratio of Cr and Si is 3 : 7 as in the resistive layer forming step. That is, the first high-nitrogen-containing layer 21 can be formed using the same device and material as those in the resistive layer forming step, and the first high-nitrogen-containing layer can be formed at lower cost.

The method for manufacturing the chip resistor 10 according to the present embodiment further includes a heat treatment step. The heat treatment step is a step of performing heat treatment on the resistive layer 2 formed in the resistive layer forming step for the purpose of adjusting the TCR. In the heat treatment step, heat treatment is performed in a temperature range between 500°C and 700°C both inclusive, under an atmosphere containing oxygen. As a result, a temperature coefficient of resistance (TCR) indicating a change in resistance per degree of absolute temperature of the resistive layer is adjusted, and a part of the surface of the first high-nitrogen-containing layer is oxidized to form an oxide layer. The heat treatment step is performed, for example, after the resistive layer forming step and the first high-nitrogen-containing layer forming step. The "heat treatment temperature" mentioned herein is the actual temperature of the resistive layer 2 in the present embodiment, but may be an ambient temperature.

In the method for manufacturing the chip resistor 10 according to the present embodiment, since the resistive layer 2 is formed by reactive sputtering as described above, the ratio of elements contained in the target of the resistive layer 2 is substantially the same as the target composition. Therefore, the chemical composition of the resistive layer 2 can be controlled.

In the resistive layer forming step and the first high-nitrogen-containing layer forming step, the N atomic percentage in the resistive layer and the N atomic percentage in the first high-nitrogen-containing layer may be respectively controlled by, for example, the ratio of nitrogen gas contained in the film-forming gas. That is, by increasing the ratio of the nitrogen gas contained in the film-forming gas in the first high-nitrogen-containing layer forming step rather than the resistive layer forming step, the N atomic percentage in the first high-nitrogen-containing layer can be made higher than that in the resistive layer.

Alternatively, the N atomic percentage in the resistive layer and the N atomic percentage in the first high-nitrogen-containing layer may be respectively controlled by the on-duty ratio of the applied pulse in reactive sputtering. That is, in the first high-nitrogen-containing layer forming step rather than the resistive layer forming step, the on-duty ratio of the applied pulse in reactive sputtering may be reduced to make the pulse sharper. For example, the on-duty ratio of the pulse may be 50% or less. As the on-duty ratio of the pulse decreases, the ratio at which nitrogen molecules in the plasma are dissociated into nitrogen atoms increases, and the nitrogen content of the thin film can be increased. As a result, the N atomic percentage in the first high-nitrogen-containing layer can be made higher than that in the resistive layer.

In the method for manufacturing the chip resistor 10 according to the present embodiment, as described above, the heat treatment step is performed on the resistive layer 2 and the first high-nitrogen-containing layer 21 formed in the resistive layer forming step. As a result, the surface oxynitride layer 22 is formed on the surface of the first high-nitrogen-containing layer 21.

The method for manufacturing the chip resistor 10 according to the present embodiment may further include a pattern forming step of forming a pattern of the resistive layer for adjusting the resistance value of the resistive layer. In addition, the method may include a step of forming an electrode pattern such as an end-surface electrode and a back-surface electrode, a step of forming a first protective film and a second protective film, a laser trimming step for adjusting a resistance value, a voltage aging step, a cleaning step, a division step, and the like.

### (4) Characteristics of chip resistor

### (Example)

In the configuration of the embodiment of Fig. 2, the film thickness Ft1 of the resistive layer 2 was 5 nm, and the film thickness Ft2 of the high-nitrogen-containing layer 21 was 30 nm. In the examples, the N atomic percentage of the resistive layer was 38 atom%, and the N atomic percentage of the first high-nitrogen-containing layer was 42 atom%.

### (Comparative example 1)

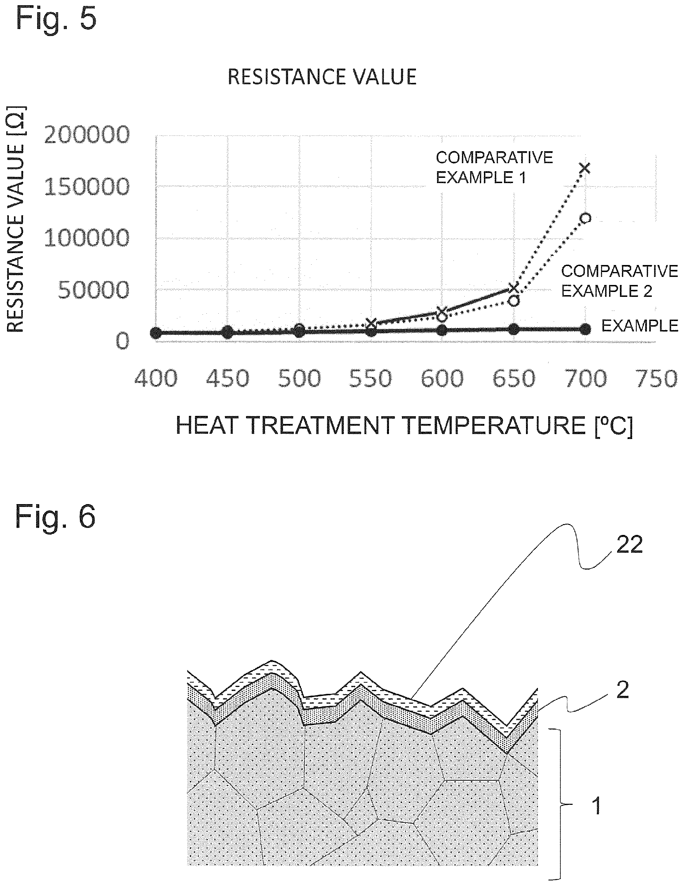

In the conventional configuration of Fig. 6, the film thickness Ft1 of the resistive layer 2 was set to 5 nm. In Comparative example 1, the N atomic percentage of the resistive layer was 38 atom%.

### (Comparative example 2)

In the conventional configuration of Fig. 6, the film thickness Ft1 of the resistor 2 was set to 10 nm. In the comparative example 2, the N atomic percentage of the resistive layer was 38 atom%.

In each of the example, the comparative example 1, and the comparative example 2, the heat treatment temperature in the heat treatment step was changed in the range of 400°C to 700°C to prepare a chip resistor.

### <Measurement>

The resistance value of the chip resistor was measured by a four-terminal method using a resistance meter.

The TCR of the chip resistor measures the resistance value of the chip resistor by changing the ambient temperature. The measurement temperature was set to three conditions of 40°C, 75°C, and 110°C. The slope of the change in the resistance value with respect to the measurement temperature was calculated, and the value obtained by dividing the slope by the resistance value at 40°C was taken as TCR [ppm/K].

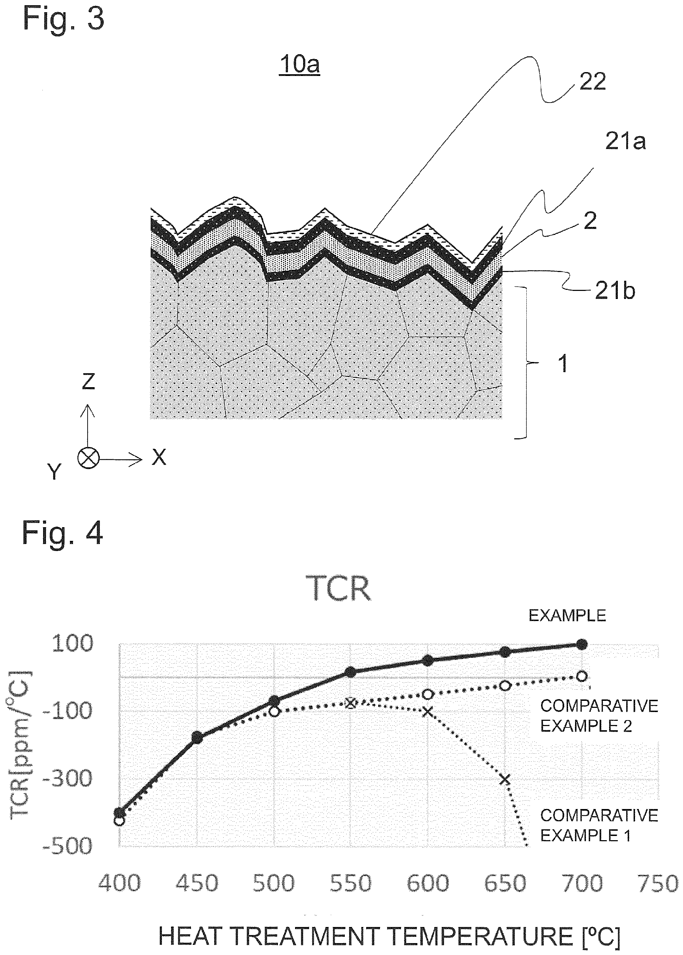

Next, characteristics of the example, the comparative example 1, and the comparative example 2 of the chip resistor 10 according to the present embodiment will be described with reference to Figs. 4 to 5.

### (4.1) TCR

First, the TCR of the characteristic 1 will be described with reference to Fig. 4. The horizontal axis in Fig. 4 represents the heat treatment temperature in the heat treatment step. The vertical axis in Fig. 4 is the TCR of the resistive layer 2.

In the example, the TCR is zero when the heat treatment temperature is between 550°C and 600°C. The rate of change of the TCR per degree of the heat treatment temperature between 550°C and 600°C is 2 ppm/K/°C (heat treatment temperature °C). In the comparative example 1, the TCR temporarily changed positively when the heat treatment temperature was increased, but the TCR was changed negatively when the heat treatment temperature was further increased, and it was not possible to adjust the TCR to zero. In the comparative example 2, the rate of change of the TCR per degree of the heat treatment temperature was 14 ppm/K/°C (treatment temperature °C) .

The chip resistor 10 according to the present embodiment can reduce the rate of change of the TCR with respect to the heat treatment temperature. That is, even when temperature variation occurs in a heat treatment furnace, for example, in the heat treatment step, it is possible to reduce the shift amount of the TCR, and it is possible to bring the TCR closer to zero. For example, even when a temperature variation of ±5°C occurs, the TCR can be set to ±10 ppm/K or less.

### (4.2) Resistance value

Next, the resistance value of the characteristic 2 will be described with reference to Fig. 5. The horizontal axis in Fig. 5 represents the heat treatment temperature in the heat treatment step. The vertical axis in Fig. 5 represents the resistance value of the chip resistor.

In the example, the rate of change in the resistance value per degree of the heat treatment temperature was 0.3%/°C (heat treatment temperature °C) in the heat treatment temperature range of 550 to 600°C in which the TCR was zero. In the comparative example 2, the heat treatment temperature was in the range of 650 to 700°C and 2.1%/heat treatment temperature °C in which the TCR was zero. In the comparative example 1, the temperature range was 650 to 700°C and 4.0%/heat treatment temperature °C.

The chip resistor 10 according to the example of the present embodiment can reduce the rate of change of the resistance value per degree of the heat treatment temperature. That is, even when temperature variation occurs in a heat treatment furnace, for example, in the heat treatment step, it is possible to reduce the shift amount of the TCR, and it is possible to bring the TCR closer to zero. For example, even when a temperature variation of ±5°C occurs, the resistance value can be reduced to ±1.5% or less.

### 5 Modification

The above-described embodiment is merely one of various embodiments of the present disclosure. The above-described embodiment can be variously modified according to design and the like as long as the object of the present disclosure can be achieved. Hereinafter, modifications of the above-described embodiment will be listed. Modifications described below can be appropriately combined and applied.

### (5.1) Modification 1

In the embodiment of the above-described embodiment, the first high-nitrogen-containing layer 21a is provided above the resistive layer 2, but as shown in Fig. 3, the second high-nitrogen-containing layer 21b may be further provided below the resistive layer body 2. In the chip resistor 10a according to the modification 1, the growth of the surface oxynitride layer (not illustrated) grown from the insulating substrate 1 side due to the unevenness and the hole (not illustrated) existing between the insulating substrate 1 and the resistive layer 2 is suppressed, and even when the film thickness Ft1 is smaller, the TCR can be adjusted to zero, and the specific resistance can be adjusted to a predetermined value.

### (Summary)

As described above, the chip resistor 10 according to the first aspect comprises: the insulating substrate 1; the resistive layer 2 formed of an alloy containing Cr, Si, and N and provided on the insulating substrate 1; and the first high-nitrogen-containing layer 21a provided on the resistive layer 2 and made of an alloy having a N atomic percentage higher than that of the resistive layer.

According to the chip resistor according to the above aspect, it is possible to achieve both high resistance and a low TCR of the resistor 2.

Note that the present disclosure includes appropriate combination of an arbitrary embodiment and/or an example among the various embodiments and/or examples described above, and effects of the respective embodiment and/or the example can be exhibited.

### EXPLANATION OF REFERENCES

- 1: insulating substrate
- 2: resistor
- 3: upper-surface electrode
- 4: first protective film
- 5: second protective film
- 6: end-surface electrode
- 7: plating layer
- 8: back-surface electrode
- 10: chip resistor
- 21: high-nitrogen-containing layer
- 22: surface oxynitride layer
- Ft1: film thickness

## Claims

1. A chip resistor comprising:
an insulating substrate;
a resistive layer formed of an alloy containing Cr, Si, and N, the resistive layer being provided on the insulating substrate; and
a first high-nitrogen-containing layer provided on the resistive layer, the first high-nitrogen-containing layer being made of an alloy having a N atomic percentage higher than a N atomic percentage of the resistive layer.

2. The chip resistor according to claim 1, further comprising, between the insulating substrate and the resistive layer, a second high-nitrogen-containing layer made of an alloy having a N atomic percentage higher than a N atomic percentage of the resistive layer.

3. The chip resistor according to claim 1 or claim 2, wherein a film thickness of the first high-nitrogen-containing layer is 1,000 nm or less.

4. The chip resistor according to any one of claims 1 to 3, wherein the composition of the alloy of the first high-nitrogen-containing layer is 40 atom% or more in a N atomic percentage.

5. The chip resistor according to any one of claims 1 to 4, wherein the alloy of the first high-nitrogen-containing layer contains at least one element selected from a group including Cr, Nb, Ta, Al, and Si.

6. The chip resistor according to any one of claims 1 to 5, wherein a composition ratio excluding elements O and N of the alloy of the first high-nitrogen-containing layer is matched with a composition ratio excluding elements O and N of the alloy of the resistive layer in a range of ±5 atom% for each constituent element.

7. A method for manufacturing a chip resistor comprising:
providing an insulating substrate;
forming a resistive layer made of an alloy containing Cr, Si, and N on the insulating substrate by reactive sputtering in an atmosphere of a film-forming gas containing nitrogen;
forming a first high-nitrogen-containing layer made of an alloy containing Cr, Si, and N and having a N atomic percentage higher than a N atomic percentage of the resistive layer on the resistive layer by reactive sputtering in an atmosphere of a nitrogen-containing film-forming gas; and
performing a heat treatment in a temperature range between 500°C and 700°C both inclusive in an atmosphere containing oxygen to adjust a temperature coefficient of resistance (TCR) indicating a change in resistance per degree of absolute temperature of the resistive layer, and oxidizing a part of a surface of the first high-nitrogen-containing layer to form an oxide layer.

8. The method for manufacturing a chip resistor according to claim 7, wherein, in the forming the resistive layer and the forming the first high-nitrogen-containing layer, the N atomic percentage in the resistive layer and the N atomic percentage in the first high-nitrogen-containing layer are respectively controlled by the ratio of nitrogen gas contained in the film-forming gas.

9. The method for manufacturing a chip resistor according to claim 7, wherein, in the forming the resistive layer and the forming the first high-nitrogen-containing layer, the N atomic percentage in the resistive layer and the N atomic percentage in the first high-nitrogen-containing layer are respectively controlled by an on-duty ratio of an applied pulse in the reactive sputtering.
